# NEUE EUROPÄISCHE PATENTSCHRIFT

(11) **EP 0 432 712 B2**
(45) Veröffentlichungstag und Bekanntmachung des Hinweises auf die Entscheidung über den Einspruch: **08.09.1999**
(45) Hinweis auf die Patenterteilung: 06.03.1996
(21) Anmeldenummer: 90123762.8
(22) Anmeldetag: 11.12.1990
(51) Int. Cl.: G03F 7/28, G03F 3/10

(54) **Verfahren zur Herstellung von Bildern auf tonbaren lichtempfindlichen Schichten**
Process for the preparation of images on tonable light-sensitive layers
Procédé pour la préparation d'images sur de couches pigmentables et photosensitives

(30) Priorität: 15.12.1989 DE 3941493
(43) Veröffentlichungstag der Anmeldung: 19.06.1991
(73) Patentinhaber: E.I. DU PONT DE NEMOURS AND COMPANY, Wilmington Delaware 19898 (US)
(72) Erfinder: Metzger, Bernhard, Dr., W-6100 Darmstadt (DE); Fröhlich, Helmut Herbert, Dr., W-6056 Heusenstamm (DE)
(74) Vertreter: Patentanwälte Lippert, Stachow, Schmidt & Partner

(56) Entgegenhaltungen:
- EP-A- 0 281 031
- EP-A- 0 365 361
- DE-A- 3 706 528
- FR-A- 2 444 287
- US-A- 3 060 025
- US-A- 3 573 918
- US-A- 3 649 268
- US-A- 4 806 451
- US-A- 4 869 996

## Beschreibung

Gegenstand der vorliegenden Anmeldung ist ein Verfahren zur Herstellung von Bildern auf tonbaren lichtempfindlichen Schichten.

Auf dem photographischen Reproduktionssektor werden lichtempfindliche Aufzeichnungsmaterialien verwendet, bei denen zur Bilderzeugung Unterschiede in der Klebrigkeit der belichteten und unbelichteten Bereiche der lichtempfindlichen Schicht ausgenutzt werden. So ist z.B. aus den deutschen Patentschriften 12 10 321, 19 04 058, 19 04 059 und 20 04 214 ein Reproduktionsverfahren bekannt, bei dem ein klebriges photopolymerisierbares Aufzeichnungsmaterial, bestehend aus einem Schichtträger und einer photopolymerisierbaren Schicht, die mindestens ein additionspolymerisierbares Monomeres und einen Photopolymerisationsinitiator enthält, durch bildmäßige Belichtung gehärtet wird, wobei die belichteten Bildteile ihre Klebrigkeit verlieren. Das latente Bild wird dann durch Aufbringen geeigneter Tonermaterialien sichtbar gemacht, die nur an den unbelichteten, klebrigen Stellen haften, während sie von den belichteten, nicht klebenden Bildteilen nach dem Aufbringen wieder entfernt werden können. Nach diesem Verfahren erhält man positive, gegebenenfalls gefärbte Bilder der Vorlage, die im Aussehen Bildern gleichen, die unter Verwendung von Druckfarben hergestellt wurden. Das Verfahren hat daher insbesondere in der Druckindustrie zur Prüfung von Farbauszügen erhebliche praktische Bedeutung erlangt.

Das Aufbringen der überwiegend aus feinteiligen Pulvern bestehenden Tonermaterialien kann durch Bestäuben der bildmäßig belichteten Oberfläche mit dem Toner erfolgen. Nach einer anderen Ausführungsform kann sich der Toner auch lose gebunden auf einem gesonderten Träger befinden und durch in Kontaktbringen dieses Trägers mit der bildmässig belichteten Schicht übertragen werden.

So ist es z.B. aus der DE-PS 12 05 117 bekannt, für thermische Übertragungsverfahren auf einen Schichtträger aufgebrachte, aus dem Tonermaterial und ggf. einem Bindemittel bestehende Schichten zu verwenden.

Aus der DE-PS 29 49 462 sind pigmentierte Schichten zur Herstellung von farbigen Bildern bekannt, die 75 - 95 Gew.-Teile Pigment und 25 - 5 Gew.-Teile eines elastomeren Bindemittels, mit einer maximalen Zugspannung von < 1.38 N/mm² und einer Bruchdehnung von wenigstens 50 %, enthalten. Nach diesem Verfahren erhält man Bilder hoher Opazität, die bevorzugt zur Wiedergabe von Schriften und Schaustücken verwendet werden. Infolge der hohen Opazität ist das Verfahren jedoch nicht für Farbprüfverfahren geeignet. Eine Herabsetzung des Pigmentgehaltes führt zwar zu einer verringerten Dichte, bewirkt aber den totalen Verlust der Auflösung.

In der DE-PS 12 85 876 sind photopolymersierbare Aufzeichnungsmaterialien für die thermische Bildübertragung beschrieben, die zwischen der photopolymerisierbaren Schicht und der Trägerfolie eine, ggf. ein Pigment enthaltende, Schicht aus einem thermoplastischen Polymer, wie z.B. Polyethylen oder Ethylen-Vinylacetat-Copolymere, in Kombination mit einem Wachs enthalten, wobei die unbelichteten Bereiche der photopolymersierbaren Schicht mit anhaftenden Teilen der Zwischenschicht thermisch übertragen werden können. Da die Teile der Zwischenschicht, die den unbelichteten Bereichen entsprechen, bei dieser übertragung nur teilweise an der photopolymerisierbaren Schicht haften, können die auf dem Schichtträger verbleibenden Anteile für weitere Übertragungen genutzt werden. Nach mehreren übertragungen bleibt ein klares Negativ auf dem Schichtträger zurück. Da pro übertragung immer nur ein Teil der Zwischenschicht übertragen wird, sind Schwankungen in der Farbdichte der übertragenden Bereiche unvermeidbar.

In der Reproduktionstechnik werden bekanntlich gerasterte Farbauszüge als Kopiervorlagen für die Herstellung von Offset- oder Hochdruckplatten verwendet. Bevor die Belichtung der Druckplatten erfolgt, werden die Farbauszüge mit Hilfe von Farbprüfverfahren daraufhin überprüft ob das spätere Druckergebnis eine tonwertrichtige Reproduktion der Vorlage darstellt.

Nach allgemeinen Standardvorschriften wird z.B. für einen hochwertigen Offsetdruck eine Auflösung von 2% - 98% Punkten bei einer Rasterweite von 60 Linien/cm gefordert, wobei es besonders schwierig ist, eine befriedigende Auflösung der spitzen 2% Punkte in den Lichtern und der 98% Punkte in den Schatten zu erreichen. Für eine gute Tonwertwiedergabe ist es ferner von erheblicher Bedeutung, daß Rasterpunkte gleicher Größe über den gesamten Flächenbereich scharf begrenzt und gleichmäßig, d.h. ohne Schwankungen in der Größe wiedergegeben werden. Mit der fortschreitenden technischen Entwicklung der Druckmaschinen, die heute eine Auflösung von 1% bis 99% Punkten erreichen können, werden aber auch die Anforderungen an die Farbprüfverfahren immer höher. Auch erzielen moderne Druckmaschinen einen immer kleineren Punktzuwachs, der von Farbprüfverfahren nachvollzogen werden muß.

Die nachveröffentlichte EP-A-0 365 361 beschreibt ein gattungsgemäßes Verfahren, bei dem die Laminierung der Übertragungsschicht unter erhöhter Temperatur, beispielsweise 60-120°C, vorgenommen wird.

Zwar ist es mit den in der DE-PS 36 25 014 beschriebenen übertragungsmaterialien, deren wesentliches Merkmal ein spezielles Bindemittelsystem inkompatibler Polymere ist, möglich, den Standardvorschriften weitgehend zu genügen - eine Auflösung von 2% - 98% Punkten wird erreicht - jedoch kann der von modernen Druckmaschinen erzielte niedrige Punktzuwachs nicht erreicht werden. Auch der Herstellungsprozeß ist zeit- und kostenintensiv, und ein kontrollierbarer Schichtaufbau ist nur schwer zu erzielen. Weiterhin ist es nachteilig, daß die Pigmente getrennt gemahlen werden müssen, daß die Produktionsansätze sofort weiterverarbeitet werden müssen und daß während des gesamten Herstellungsprozesses für eine intensive Durchmischung der Dispersionen gesorgt werden muß, um Absetzen und Verklumpen der Bestandteile zu vermeiden. Nur so kann ein einheitlicher Auftrag auf das Trägermaterial gewährleistet werden. Auch muß die Auftragsgeschwindigkeit niedrig sein, wodurch der Produktionsprozeß zusätzlich nachteilig beeinflußt wird.

Aufgabe der vorliegenden Erfindung ist es daher, ein Verfahren zur Herstellung von Bildern auf tonbaren lichtempfindlichen Schichten unter Verwendung einer mindestens ein feinteiliges Pulver oder ein feinteiliges Pulver und einen gelösten Farbstoff enthaltenden übertragungsschicht anzugeben, mit dem die von der Druckindustrie geforderte hohe Auflösung von 1 % - 99 % Punkten erreicht werden kann, das sich durch eine hohe Gleichmäßigkeit der Rastertonwerte über die gesamte Fläche und einen sehr geringen Punktzuwachs auszeichnet, das zu dem die im Vorhergehenden beschriebenen Nachteile und Mängel vermeidet und das ferner für verschiedene tonbare lichtempfindliche Schichten anwendbar ist. Diese Aufgabe wird gelöst durch die Verwendung einer übertragungsschicht gemäß dem kennzeichnenden Teil von Anspruch 1.

Die Erfindung geht aus von einem Verfahren zur Herstellung von Bildern bei dem
a) auf einer lichtempfindlichen Schicht durch bildmäßige Belichtung klebrige und nicht-klebrige Bereiche erzeugt werden,
b) die belichtete Schicht mit einer auf einem Schichtträger befindlichen übertragungsschicht, die nicht lichtempfindlich ist und in ihrem Bindemittel mindestens ein feinteiliges Pulver oder ein feinteiliges Pulver und einen gelösten Farbstoff enthält, bei einer Temperatur unterhalb 60°C in Kontakt gebracht wird, und
c) die beiden Schichten getrennt werden,
wobei die übertragungsschicht nur an den klebrigen Bildbereichen haften bleibt.

Die Erfindung ist dadurch gekennzeichnet, daß die übertragungsschicht bis zu 8 µm dick ist, ≥20 Gew.-% der feinteiligen Pulver oder der Kombination feinteiliges Pulver/gelöster Farbstoff enthält und als Bindemittel mindestens ein Polymer mit einer maximalen Zugspannung von ≥2 N/mm² verwendet wird.

Gegen den Einsatz der erfindungsgemäßen übertragungsschicht in Farbprüfverfahren, bei denen eine hohe Auflösung, reproduzierbare Farbdichte und geringer Punktzuwachs gefordert sind, sprach, daß die erfindungswesentlichen Bindemittel noch nicht einmal den viel geringeren Anforderungen, die in der DE-PS 29 49 462 an übertragungsmaterialien gestellt werden, genügen können (Beispiel 6 und 11). Erstaunlicherweise sind aber mit den hier beschrieben Polymeren die hohen Anforderungen eines Farbprüfverfahrens erfüllbar.

Ein erheblicher Vorteil der erfindungsgemäßen übertragungsschicht gegenüber herkömmlichen Materialien ist ihre einfache, schnelle und kostengünstige Herstellung. Desweiteren sind sie mit einer Vielzahl von tonbaren, lichtempfindlichen Materialien kombinierbar. Bevorzugt werden positive, lichtempfindliche Materialien verwendet, wie sie z.B. in der US 4,356,253 beschrieben sind. Besonders gute Ergebnisse werden mit den Materialien der EP-A 02 43 933 erzielt. Die als Bindemittel verwendeten Polymere müssen eine maximale Zugspannung von ≥ 2 N/mm², bevorzugt zwischen 2 und 110 N/mm² besitzen. Besonders geeignet sind Polymere, deren max. Zugspannung zwischen 5 und 60 N/mm² liegt.

Als Beispiele für die erfindungswesentlichen Polymere seien genannt: Homo- und Copolymere aus Ethylen, Propylen, Vinylestern, Vinylchlorid, Acrylaten, Methacrylaten und Acrylamiden bzw. Methacrylamiden und Cellulosederivate.
Besonders bevorzugt werden Polymere verwendet, die in organischen Lösungsmitteln löslich sind. Insbesondere Copolymere aus Vinylacetat und Ethylen und Polymethylmethacrylate oder Polystyrole sind hervorragend geeignet. Falls gewünscht, können auch Polymermischungen verwendet werden.

Die Übertragungsschicht sollte ≥ 20 Gew.-% der feinteiligen Pulver oder der Kombination feinteiliges Pulver/gelöster Farbstoff enthalten, bevorzugt 30 - 70 Gew.-%.

Eine besonders bevorzugte Ausführungsform der neuen Übertragungsmaterialien enthält das Bindemittel und das feinteilige Pulver - z.B. ein Pigment - in ungefähr gleichen Mengen.

Zur Bildaufzeichnung geeignete feinteilige Pulver sind aus der Literatur, beispielsweise aus der DE-PS 19 04 059 und der DE-PS 29 46 896, in grosser Zahl bekannt. Bei diesen Pulvern handelt es sich überwiegend um Pigmente, jedoch sind auch gelöste Farbstoffe in Kombination mit einem feinteiligen Pulver brauchbar. Als Beispiele seien genannt anorganische und organische Pigmente, Leuchtstoffe, Metallpulver in reiner Form oder zusammen mit einem pulverförmigen organischen oder anorganischen Träger, wie Titandioxyd, Glaspulver, Kohlenstoff (Ruß oder Graphit), Metall-Phthalocyanine, Azofarbstoffe, Metallpulver aus Aluminium, Kupfer, Eisen, Gold oder Silber oder Metalloxyde. Besonders vorteilhaft ist die Verwendung einer Mischung aus Pigment und SiO₂. Die Herstellung der Beschichtungsmasse erfolgt nach bekannten Methoden.

Zur Herstellung der Übertragungsschicht wird die Beschichtungsmasse nach bekannten Methoden auf einen geeigneten Schichtträger aufgetragen und anschließend getrocknet. Bevorzugt werden die Pigment/Bindemittel Mischungen aus organischen Lösungsmitteln auf die Schichtträger aufgebracht.
Geeignete Schichtträger sind insbesondere Papier und Kunststoffolien aus Polyestern, Polyamiden, Polyethylen, Polypropylen, Polyvinylchlorid u. dgl. Besonders vorteilhaft sind kompressible Materialien, wie sie in der DE-PS 37 065 28 beschrieben werden.

Die Dicke der getrockneten Schicht beträgt bis zu 8 µm, bevorzugt bis zu 5 µm. Es ist aber mit der vorliegenden Erfindung möglich, sehr dünne Schichten mit einer Dicke < 3 µm, bevorzugt 0.4 - 1.5 µm, herzustellen, die besonders für Farbprüfverfahren geeignet sind, die eine sehr hohe Auflösung und einen sehr niedrigen Punktzuwachs erfordern. Insbesondere 1 µm dicke Schichten auf einer Polypropylen-Schaumfolie gemäß DE-OS 37 06 528 sind für diese Zwecke sehr geeignet.
Außer den bereits genannten Bestandteilen kann die Beschichtungsmasse noch andere Zusätze, wie Netzmittel, Gießhilfsmittel, Gleitmittel, Mittel zur Erhöhung der Viskosität, Mittel zur Haftungskontrolle und dergleichen enthalten.

Das vorliegende Verfahren eignet sich zur Bilderzeugung auf allen lichtempfindlichen Schichten, die durch bildmäßige Belichtung in klebrige und nicht-klebrige Bereiche modifizierbar sind. Die lichtempfindliche Schicht kann sowohl aus positiv als auch negativ tonbaren Systemen bestehen.
Als positiv tonbare Systeme sind photohärtbare, vor allem jedoch die photopolymerisierbaren Systeme geeignet, wie sie in den deutschen Patentschriften 12 10 321, 19 04 058, 19 04 059 und 20 04 214 beschrieben sind. Diese photopolymerisierbaren Systeme enthalten als wesentliche Bestandteile ein oder mehrere additionspolymerisierbare Monomere, ein Bindemittel oder ein Bindemittelgemisch und einen Photoinitiator bzw. ein Initiatorsystem. Besonders geeignet sind die Materialien der EP-A 02 43 933.
Negativ tonbare Systeme sind ebenfalls bekannt und beispielsweise in den Deutschen Patentschriften 27 58 209, 30 23 247 und 34 29 615 beschrieben. Diese Systeme enthalten als lichtempfindliche Komponenten entweder eine lichtempfindliche Dihydropyridinverbindung oder ein lichtempfindliches System bestehend aus einer Dihydropyridinverbindung und einer Hexaarylbisimidazolverbindung.

Die lichtempfindlichen Materialien besitzen ihre maximale Empfindlichkeit im Ultraviolettbereich, bevorzugt im Wellenlängenbereich zwischen 250 und 450 nm. Zur Belichtung sind daher alle Strahlungsquellen geeignet, die eine wirksame Menge dieser Strahlung liefern, beispielsweise Xenonlampen, Quecksilberdampflampen und Kohlebogenlampen, Laser, Fluoreszenzlampen mit UV-Strahlung emittierenden Leuchtstoffen und Elektronenblitzgeräte. Das erfindungsgemäße Verfahren kann mit Vorteil zur Wiedergabe von Strich- und Rasteraufnahmen für die Anwendung im graphischen und sonstigen industriellen Bereichen, zur Herstellung von Landkarten Werbedrucken, Plakaten, Leuchtschriften und zur Herstellung gedruckter Schaltungen verwendet werden.
Das Hauptanwendungsgebiet liegt jedoch in der Herstellung von Ein- oder Mehrfarbenbildern und in der Verwendung für Farbprüfverfahren.

Die Durchführung eines Farbprüfverfahrens gemäß der vorliegenden Erfindung umfaßt die folgenden Verfahrensschritte:

Das lichtempfindliche Material z. B. ein Laminat aus einer auf eine Trägerfolie aufgetragenen photopolymerisierbaren Schicht mit einer Deckfolie wird nach Entfernung der Deckfolie auf ein Bildempfangsmaterial aufgebracht und durch den transparenten Schichtträger hindurch, je nach dem ob es sich um ein positiv oder negativ arbeitendes System handelt, unter Verwendung eines gerasterten Farbauszugs-Positivs oder -Negativs einer ersten Farbe als Vorlage mit aktinischer Strahlung zur Ausbildung von klebrigen und nicht klebrigen Bereichen belichtet und die Übertragungsschicht auf die belichtete Schicht auf laminiert und wieder abgezogen. Man erhält ein gefärbtes Bild der Vorlage. Ein zweites Laminat des lichtempfindlichen Materials wird nach Entfernung der Deckfolie auf das Bild auflaminiert und unter gleichen Bedingungen durch ein gerastertes Farbauszugs-Negativ oder -Positiv einer zweiten Farbe als Vorlage belichtet und durch Auflaminieren und wieder Abziehen der Übertragungsschicht getont.

Dieser Vorgang wird dann für einen Farbauszug einer dritten Farbe und falls erwünscht, für einen Schwarzauszug wiederholt.
Man erhält ein den Vorlagen entsprechendes vierfarbiges Bild. Ein besonderer Vorteil des erfindungsgemäßen Verfahrens besteht darin, daß man, ausgehend von einem positiv arbeitenden lichtempfindlichen System, auch mit negativen Farbauszügen als Vorlage 4-farbige Overlays und daraus einen positiven Farbprüfdruck herstellen kann.

Wird von negativen Farbauszügen ausgegangen, so wird zunächst ein Prüfdruck nach der oben angegebenen Verfahrensweise hergestellt. Die auf den für die übertragung der Teilfarben verwendeten Übertragungsschichten verbleibenden Restbilder werden dann zur Herstellung des Prüfdruckes unter Verwendung von klebenden Zwischenschichten, unter Anwendung von Druck und/oder Wärme und nachfolgendem Abzug des Schichtträgers übereinander laminiert.
Nach einer anderen Ausführungsform ist es jedoch auch möglich, die auf den Übertragungsschichten verbleibenden Restbilder als Overlay übereinander zu legen.
Im Vergleich mit den Übertragungsmaterialien der DE-PS 36 25 014 sind die erfindungsgemäßen Übertragungsschichten wesentlich zeit- und kostengünstiger und mit gleichbleibender Qualität herstellbar, wobei zudem ein einheitlicherer Auftrag und eine Farbschicht mit geringeren Dichteschwankungen erhalten wird. Dadurch wird eine fehlerfreie Übertragung und eine hohe Auflösung erzielt, wobei der Punktzuwachs gering ist. Durch den Einsatz der erfindungsgemäßen Polymere werden pigmentierte Schichtübertragungsmaterialien mit kontrollierbarem Aufbau erhalten.

Die nachfolgenden Beispiele sollen die Erfindung veranschaulichen.

Die angegenen Teile und Prozente beziehen sich, falls nichts anderes angegeben ist, auf das Gewicht.

### Beispiel 1

Zur Herstellung einer erfindungsgemäßen übertragungsschicht werden 13,3 g Ethylen-Vinylacetat Copolymer (18 % Vinylacetat, max.Zugspannung 2.9 N/mm² gemäß ASTM D-882), 19,8 g Cyan-Pigment auf Kupferphthalocyaninbasis (C.I. 74160) und 0,2 g Netzmittel mit der Hälfte eines Lösungsmittelgemischs aus Toluol, Methylethylketon und Xylol (60:35:5, insgesamt 333 g) in einer Perlmühle gemahlen. Anschließend wird unter starkem Rühren das restliche Lösungsmittel zugegeben. Die Beschichtungsmasse wird dann so auf eine 60 µm dicke Polypropylen-Schaumfolie gemäß DE-OS 37 06 528 aufgetragen, daß nach dem Trocknen eine 1,5 µm dicke Schicht erhalten wird mit fehlerfreier Oberfläche ohne Dichteschwankungen.
Zur Herstellung des Farbbilds wird eine gemäß den Angaben von Beispiel 1 der EP-A 02 43 933 hergestellte, positiv tonbare, photopolymerisierbare Schicht nach Entfernung der Deckfolie auf ein Bildempfangsmaterial auflaminiert und durch einen gerasterten Cyan-Farbauszug in einem Vakuumkopierrrahmen mit einer Metallhalogenidlampe (3000 Watt) unter Verwendung eines UV-Filters 42 s im Abstand von 95 cm belichtet. Nach Entfernung des Schichtträgers wird die das Tonermaterial enthaltende übertragungsschicht auf die bildmäßig belichtete Schicht auflaminiert und sofort wieder abgezogen. Die übertragungsschicht bleibt nur auf den unbelichteten, klebrigen Stellen haften, und man erhält ein positives Cyanbild der Vorlage mit einer Auflösung von 1 % - 99 % Punkten im 60-Linien/cm-Raster.

### Beispiel 2

Gemäß den Angaben im Beispiel 1 wird eine 1.0 µm dicke übertragungsschicht aus den folgenden Bestandteilen hergestellt und verarbeitet:

| | |
|---|---|
| 16.5 g | Ethylen-Vinylacetat Copolymer (40 % Vinylacetat, max. Zugspannung 5.3 N/mm² gemäß ASTM D-882) |
| 8.3 g | Cyan-Pigment auf Kupferphthalocyaninbasis (C.I. 74160) |
| 8.3 g | amorphes SiO₂ |
| 0.2 g | Netzmittel |
| 333 g | Lösungsmittel (Toluol/Methylethylketon/Xylol, 60:35:5) |

Man erhält so ein positives Cyanbild der Vorlage mit einer Auflösung von 1 % - 99 % Punkten im 60-Linien/cm-Raster.

### Beispiel 3

Gemäß den Angaben im Beispiel 1 wird eine 0.35 µm dicke übertragungsschicht aus den folgenden Bestandteilen hergestellt und verarbeitet:

| | |
|---|---|
| 4.18 g | Polystyrol (max. Zugspannung 23 N/mm² gemäß DIN 53455) |
| 4.13 g | Cyan-Pigment auf Kupferphthalocyaninbasis (C.I. 74160) |
| 0.05 g | Netzmittel |
| 83.3 g | Lösungsmittel (Toluol/Methylethylketon/Xylol, 60:35:5) |

Man erhält so ein positives Cyanbild der Vorlage mit einer Auflösung von 1 % - 99 % Punkten im 60-Linien/cm-Raster.

### Beispiel 4

Gemäß den Angaben im Beispiel 1 wird eine 0.4 µm dicke übertragungsschicht aus den folgenden Bestandteilen hergestellt und verarbeitet:

| | |
|---|---|
| 3.34 g | Polystyrol (max. Zugspannung 23 N/mm² gemäß DIN 53455) |
| 0.82 g | Ethylen-Vinylacetat Copolymer (40% Vinylacetat, max. Zugspannung 5.3 N/mm² gemäß ASTM D-882 |
| 4.13 g | Cyan-Pigment auf Kupferphthalocyaninbasis (C.I. 74160) |
| 0.13 g | Netzmittel |
| 83.3 g | Lösungsmittel (Toluol/Methylethylketon/Xylol, 60:35:5) |

Man erhält so ein positives Cyanbild der Vorlage mit einer Auflösung von 1 % - 99 % Punkten im 60-Linien/cm-Raster.

### Beispiel 5

Gemäß den Angaben im Beispiel 1 wird eine 0.7 um dicke übertragungsschicht aus den folgenden Bestandteilen hergestellt und verarbeitet:

| | |
|---|---|
| 4.18 g | Polystyrol (max. Zugspannung 55 N/mm² gemäß DIN 53455) |
| 4.13 g | Cyan-Pigment auf Kupferphthalocyaninbasis (C.I. 74160) |
| 0.05 g | Netzmittel |
| 83.3 g | Lösungsmittel (Toluol/Methylethylketon/Xylol, 60:35:5) |

Man erhält so ein positives Cyanbild der Vorlage mit einer Auflösung von 1 % - 99 % Punkten im 60-Linien/cm-Raster.

### Beispiel 6

Gemäß den Angaben im Beispiel 1 wird eine 0.4 um dicke übertragungsschicht aus den folgenden Bestandteilen hergestellt und verarbeitet:

| | |
|---|---|
| 24.8 g | Polyvinylacetat |
| 8.3 g | Cyan-Pigment auf Kupferphthalocyaninbasis (C.I. 74160) |
| 0.2 g | Netzmittel |
| 333 g | Lösungsmittel (Toluol/Methylethylketon/Xylol, 60:35:5) |

Man erhält so ein positives Cyanbild der Vorlage mit einer Auflösung von 1 % - 99% Punkten im 60-Linien/cm-Raster.

### Beispiel 7

Gemäß den Angaben im Beispiel 1 wird eine 0.5 µm dicke übertragungsschicht aus den folgenden Bestandteilen hergestellt und verarbeitet:

| | |
|---|---|
| 4.2 g | Polymethylmethacrylat (max. Zugspannung 55 N/mm² gemäß ASTM D-638) |
| 4.1 g | Cyan-Pigment auf Kupferphthalocyaninbasis (C.I. 74160) |
| 0.05 g | Netzmittel |
| 83.3 g | Lösungsmittel (Toluol/Methylethylketon/Xylol, 60:35:5) |

Man erhält so ein positives Cyanbild der Vorlage mit einer Auflösung von 1 %- 99 % Punkten im 60-Linien/cm-Raster.

### Beispiel 8

Gemäß den Angaben im Beispiel 1 wird eine 0.6 um dicke übertragungsschicht aus den folgenden Bestandteilen hergestellt und verarbeitet:

| | |
|---|---|
| 4.2 g | Polymethylmethacrylat (max. Zugspannung 106 N/mm² gemäß ASTM D-638) |
| 4.1 g | Cyan-Pigment auf Kupferphthalocyaninbasis (C.I. 74160) |
| 0.1 g | Netzmittel |
| 83 g | Lösungsmittel (Toluol/Methylethylketon/Xylol, 60:35:5) |

Man erhält so ein positives Cyanbild der Vorlage mit einer Auflösung von 1 % - 99 % Punkten im 60-Linien/cm-Raster.

### Beispiel 9

Gemäß den Angaben im Beispiel 1 wird eine 0.4 um dicke übertragungsschicht aus den folgenden Bestandteilen hergestellt und verarbeitet:

| | |
|---|---|
| 4.2 g | Methylmethacrylat -Butylmethacrylat-Copolymer (max. Zugspannung 11 N/mm² gemäß ASTM D-638) |
| 4.1 g | Cyan-Pigment auf Kupferphthalocyaninbasis (C.I. 74160) |
| 0.1 g | Netzmittel |
| 83 g | Lösungsmittel (Toluol/Methylethylketon/Xylol, 60:35:5) |

Man erhält so ein positives Cyanbild der Vorlage mit einer Auflösung von 1 % - 99 % Punkten im 60-Linien/cm-Raster.

### Beispiel 10

Gemäß den Angaben im Beispiel 1 wird eine 1.8 um dicke übertragungsschicht aus den folgenden Bestandteilen hergestellt und verarbeitet:

| | |
|---|---|
| 100 g | Styrol-Butadien Copolymer (50 %ige wäßrige Suspension, 45 % Styrol, max. Zugspannung 0.4 N/mm² gemäß ASTM D 412-75) |
| 112,5 g | Cyan-Pigment auf Kupferphthalocyaninbasis (C.I. 74160) |
| 0.5 g | anionisches Fluornetzmittel |
| 437 g | entionisiertes Wasser |

Mit den in diesem Beispiel verwendeten, nicht erfindungsgemäßen Bindemitteln kann keine ausreichende Auflösung bei der bildmäßigen übertragung der Pigmentschicht erzielt werden.

### Beispiel 11

Gemäß den Angaben im Beispiel 1 wird eine 0.45 µm dicke übertragungsschicht aus den folgenden Bestandteilen hergestellt und verarbeitet:

| | |
|---|---|
| 3.34 g | Ethylen-Vinylacetat Copolymer (40% Vinylacetat, max. Zugspannung 5.3 N/mm² gemäß ASTM D-882) |
| 0.83 g | Nitrocellulose (Stickstoffgehalt < 12.6%) |
| 4.3 g | Cyan-Pigment auf Kupferphthalocyaninbasis (C.I. 74160) |
| 0.13 g | Netzmittel |
| 83.3 g | Lösungsmittel |

Man erhält so ein positives Cyanbild der Vorlage mit einer Auflösung von 1 % - 99 % Punkten im 60-Linien/cm-Raster.

### Beispiel 12

Die zur Herstellung eines Vierfarbbildes benötigten übertragungsschichten der Farben Cyan, Magenta, Gelb und Schwarz werden hergestellt, indem man die in der Tabelle 1 angegebenen Mengen Pigment, Bindemittel und Netzmittel in einer Perlmühle mit 40 bis 60% des insgesamt benötigten Lösungsmittelgemisches aus Toluol, Methylethylketon und Xylol 6:3:1) mahlt. Anschließend wird unter starkem Rühren das restliche Lösungsmittel zugegeben.

**Tabelle 1**

| | CYAN(g) | MAGENTA(g) | GELB(g) | SCHWARZ(g) |
|---|---|---|---|---|
| Pigment | 52,50 | 80 | 35,0 | 50 |
| amorphes SiO₂ | 15,00 | 50 | 8,0 | 40 |
| Ethylenvinylacetat Copolymer 18% | 80,55 | 116,75 | 56,0 | 107,4 |
| Vinylacetat max. Zugspannung:5,9 N/mm² | | | | |
| gemäß ASTMD-882 | | | | |
| anionisches Netzmittel | 1,95 | 3,25 | 1,0 | 2,6 |
| Lösungsmittel | 850,0 | 750,0 | 900,0 | 800,0 |

Als Pigmente werden für die Cyan-übertragungsschicht eine Mischung eines Cyan-Pigments auf Kupferphtalocyaninbasis (C.I. 74160) und eines Magenta-Pigments (C.I. Pigment Red 123), für die Magenta-übertragungsschicht ein Gemisch zweier Magenta-Pigmente (C.I. Pigment Red 122 und Pigment Red 123) und für die Gelbübertragungsschicht das Farbpigment C.I. Pigment Yellow 17 verwendet. Die übertragungsschicht für Schwarz enthält C.I. Pigment Black 7. Die Beschichtungsmasse wird mit einem 80 Linien/cm Linienraster mit einer Druckgeschwindigkeit von 150 m/min im direkten Gravurdruck auf eine 60 µm dicke Polypropylenschaumfolie gemäß DE-OS 37 06 528 so aufgedruckt, daß nach dem Trocknen eine 1 µm dicke Schicht erhalten wird mit fehlerfreier Oberfläche ohne Dichteschwankungen.
Eine Corona-Behandlung der Folie zur Erhöhung der Oberflächenspannung ist nicht erforderliche.
Die Farbdichte der einzelnen Schichten beträgt:

| | |
|---|---|
| Cyan | 1.30 |
| Magenta | 1.40 |
| Gelb | 1.30 |
| Schwarz | 1.70 |

Zur Herstellung eines Vierfarben-Prüfdruckes wird eine gemäß den Angaben von Beispiel 1 der EP-A 02 43 933 hergestellte, positiv tonbare photopolymerisierbare Schicht nach Entfernung der Deckfolie auf ein Bildempfangsmaterial auflaminiert und durch einen gerasterten positiven Cyan-Farbauszug in einem Vakuumkopierrahmen mit einer Metallhalogenidlampe (3000 Watt) unter Verwendung eines Ultraviolett-Filters 42 s im Abstand von 95 cm belichtet. Nach Entfernung des Schichtträgers wird die das Pigmentmaterial enthaltende übertragungsschicht a) auf die bildmäßig belichtete Schicht auflaminiert und sofort wieder abgezogen. Die übertragungsschicht bleibt nur auf den unbelichteten, klebrigen Stellen haften, und man erhält ein positives Cyanbild der Vorlage.

Eine zweite Schicht des positiv tonbaren photopolymerisierbaren Aufzeichnungsmaterials wird auf das Cyanbild auflaminiert und wie oben durch den entsprechenden gerasterten Magenta-Farbauszug belichtet. Nach Entfernung des Schichtträgers wird die das Pigmentmaterial enthaltende übertragungsschicht b) auf die bildmäßig belichtete Schicht auflaminiert und wieder abgezogen. Die übertragungsschicht bleibt nur an den unbelichteten klebrigen Stellen haften, und man erhält ein positives Magenta-Bild. Für die Farben Gelb und Schwarz werden die Arbeitsschritte entsprechend wiederholt und anschließend in üblicher Weise eine Schutzschicht aufgebracht. Man erhält einen Vierfarben-Prüfdruck von ausgezeichneter Brillianz und Schärfe mit einer Auflösung von 1% - 99% im 60-Linien/cm Raster, der eine naturgetreue Wiedergabe des Originals darstellt. Die Punktzuwächse liegen bei allen vier Farben um 19% im Mitteltonbereich.

## Patentansprüche

1. Verfahren zur Herstellung von Bildern, bei dem
A) auf einer lichtempfindlichen Schicht durch bildmäßige Belichtung klebrige und nichtklebrige Bereiche erzeugt werden,
B) die belichtete Schicht mit einer auf einem Schichtträger befindlichen Übertragungsschicht, die nicht lichtempfindlich ist und in ihrem Bindemittel mindestens ein feinteiliges Pulver oder ein feinteiliges Pulver und einen gelösten Farbstoff enthält, bei einer Temperatur unterhalb 60 °C in Kontakt gebracht wird, und
C) die beiden Schichten getrennt werden,
dadurch gekennzeichnet, daß
die Übertragungsschicht bis zu 8 µm dick ist, ≥ 20 Gew.-% der feinteiligen Pulver oder der Kombination feinteiliges Pulver/gelöster Farbstoff enthält und als Bindemittel mindestens ein Polymer mit einer maximalen Zugspannung von ≥ 2 N/mm² verwendet wird.

2. Verfahren nach Anspruch 1
dadurch gekennzeichnet, daß
die Übertragungsschicht 30 - 70 Gew.% der feinteiligen Pulver oder der Kombination feinteiliges Pulver/gelöster Farbstoff enthält.

3. Verfahren nach Anspruch 1 bis 2
dadurch gekennzeichnet,daß
die feinteilgen Pulver organische oder anorganische Pigmente sind.

4. Verfahren nach Anspruch 1 bis 3
dadurch gekennzeichnet, daß
mindestens ein Polymer mit einer maximalen Zugspannung zwischen 2 und 110 N/mm² verwendet wird.

5. Vertahren nach Anspruch 1 bis 4
dadurch gekennzeichnet, daß
die Dicke der Übertragungsschicht unter 3 µm liegt.

6. Vertahren nach Anspruch 1 bis 5
dadurch gekennzeichnet, daß
der Schichtträger aus einem kompressiblen Material besteht.

7. Verfahren nach Anspruch 1 bis 6
dadurch gekennzeichnet, daß
als tonbare lichtempfindliche Schicht eine photopolymerisierbare Schicht verwendet wird, die mindestens ein photopolymerisierbares Monomeres, einen Photoinitiator bzw. Initiatorsystem und ein Bindemittel bzw. Bindemittelgemisch enthält.

8. Verfahren zur Herstellung von Mehrfarbenbildern nach einem Verfahren gemäß Anspruch 1, wobei als feinteiliges Pulver ein feinteiliges Pigment verwendet wird und nach Trennung der beiden Schichten
D) auf das entstandene Bild eine neue lichtempfindliche Schicht aufgebracht wird, und
E) die Schritte A - D mehrfach wiederholt werden.

## Claims

1. A process for preparing images comprising
A) producing tacky and non-tacky areas on a light-sensitive layer by imagewise exposure,
B) contacting at a temperature below 60 °C the exposed layer with a transfer layer on a support, which transfer layer is not light-sensitive and contains in its binder at least one finely divided powder or a finely divided powder and a dissolved dye, and
C) separating the two layers,
characterizied in that
the transfer layer is up to 8 µm thick, contains ≥ 20 % by weight of the finely divided powder or of a combination of finely divided powder/dissolved dye and at least one polymer with a maximum tensile strength of ≥ 2 N/mm² is used as binder.

2. A process according to claim 1, characterized in that, the transfer layer contains 30 - 70 % by weight of a finely divided powder or of a combination finely divided powder/dissolved dye.

3. A process according to one of claims 1 or 2, characterized in that, the finely divided powders are organic or anorganic pigments.

4. A process according to one of claims 1 or 3, characterized in that, at least one polymer with a maximum tensile strength between 2 and 110 N/mm² is used.

5. A process according to one of claims 1 to 4, characterized in that, the thickness of the transfer layer is less than 3 µm.

6. A process according to one of claims 1 to 5, characterized in that, the support layer consists of a compressible material.

7. A process according to one of claims 1 or 6, characterized in that, a photopolymerizable layer containing at least one photopolymerizable monomer, a photoinitiator or a initiator system, and a binder or binder mixture is used as tonable light-sensitive layer.

8. A process for preparing multi color images according to a process of claim 1, wherein as finely divide powder a finely divide pigment is used and after separation of the two layers
D) a new light-sensitive layer is applied onto the existing image, and
E) steps A - D are repeated several times.

## Revendications

1. Procédé pour la réalisation d'images, dans lequel
A) on produit sur une couche photosensible des zones collantes et non collantes, par illumination de formes d'images.
B) à une température inférieure à 60 °C, on met en contact la couche illuminée avec une couche de transfert se trouvant sur un support de couche et qui n'est pas photosensible et qui comporte dans son liant au moins une poudre finement divisée ou une poudre finement divisée et un colorant dissout, et
C) on sépare les deux couches,
caractérisé en ce que l'épaisseur de la couche de transfert est inférieur à 8 µm, en ce que la couche de transfert contient en poids ≥ 20% de poudre finement divisée ou de la combinaison poudre finement divisée/colorant dissout et en ce que l'on utilise comme liant au moins un polymère ayant une résistance à la traction ≥ 2 N/mm2.

2. Procédé selon la revendication 1, caractérisé en ce que la couche de transfert contient de 30 à 70 % en poids de poudre finement divisée ou de la combinaison poudre finement divisée/colorant dissout.

3. Procédé selon la revendication 1 à 2, caractérisé en ce que la poudre finement divisée est constituée de pigments organiques ou inorganiques.

4. Procédé selon la revendication 1 à 3, caractérisé en ce qu'on utilise au moins un polymère ayant une résistance à la traction comprise entre 2 et 110 N/mm².

5. Procédé selon la revendication 1 à 4, caractérisé en ce que l'épaisseur de la couche de transfert est inférieure à 3 µm.

6. Procédé selon la revendication 1 à 5, caractérisé en ce que le support de couche est constitué d'un matériau compressible.

7. Procédé selon la revendication 1 à 6, caractérisé en ce que l'on utilise comme couche photosensible pigmentable une couche photopolymérisable, contenant au moins un monomère photopolymérisable, un photoinitiateur, ou un système initiateur et un liant, ou un mélange de liants.

8. Procédé pour la préparation d'images polychromes suivant un procédé selon la revendication 1, dans lequel on utilise comme poudre finement divisée un pigment finement divisé et dans lequel, après séparation des deux couches,
D) on applique sur l'image produite une nouvelle couche photosensible, et
E) on répète plusieurs fois les étapes étapes A à D.
